# EUROPEAN PATENT SPECIFICATION

(11) **EP 2 856 474 B1**
(45) Date of publication and mention of the grant of the patent: **05.09.2018**
(21) Application number: 13725741.6
(22) Date of filing: 24.05.2013
(51) Int. Cl.: H01B 1/22, C09D 11/00, H01L 31/0224

(54) **TRANSPARENT ELECTRICALLY-CONDUCTIVE SOLID MATERIAL, AND METHOD AND COMPOSITION FOR FORMING TRANSPARENT ELECTRICALLY-CONDUCTIVE SOLID MATERIAL**
TRANSPARENTES, ELEKTRISCH LEITFÄHIGES, FESTES MATERIAL UND VERFAHREN UND ZUSAMMENSETZUNG ZUR BILDUNG EINES TRANSPARENTEN, ELEKTRISCH LEITFÄHIGEN, FESTEN MATERIALS
MATÉRIAU SOLIDE ÉLECTROCONDUCTEUR TRANSPARENT, ET PROCÉDÉ DE COMPOSITION POUR LA FORMATION DE MATÉRIAU SOLIDE ÉLECTROCONDUCTEUR TRANSPARENT

(30) Priority: 25.05.2012 GB 201209221
(43) Date of publication of application: 08.04.2015
(73) Proprietor: Oxford University Innovation Limited, Botley Oxford OX2 0JB (GB)
(72) Inventor: WATT, Andrew Archibald Ronald, Oxford Oxfordshire OX2 6QU (GB); NELSON, Maria, Lincoln Lincolnshire LN4 3NS (GB)
(74) Representative: Abel & Imray
(86) International application number: PCT/GB2013/051370
(87) International publication number: WO 2013/175227

(56) References cited:
- US-A1- 2010 288 531
- US-A1- 2011 094 651
- US-A1- 2012 107 598
- US-B1- 6 228 288

## Description

The present invention relates to methods for forming transparent, electrically-conductive solid materials.

The provision of transparent electrically-conductive materials, such as coatings, is well-known to those skilled in the art. Such coatings are typically made from indium tin oxide (ITO) which is deposited under low pressure conditions. Deposition of ITO is therefore an expensive process requiring specialised equipment. ITO also tends to be brittle, and therefore may be unsuitable for use on flexible substrates. Furthermore, ITO has a relatively high optical absorbance and therefore ITO tends to be deposited in relatively thin layers in order that the ITO is transparent. It can be difficult to prepare such thin layers on relatively rough substrates. Indium is expensive and the mass of indium which is economically viable to mine is limited.

The increase in adoption of flexible screens and touch-screen displays provides challenges to the application of ITO. Several flexible conductive coatings have been proposed to those skilled in the art. For example, it is known to use conductive polymers or silver nanowires to form conductive coatings. US2010/0107598 discloses transparent conductive films comprising silver nanowires dispersed in polyvinyl alcohol or gelatin. US2011/0094651 discloses a method of producing a conductive, transparent layer on a substrate. US2010/0288531 discloses a transparent, electrically-conductive film. US2012/107598 discloses the preparation of transparent conductive films comprising silver nanowires dispersed in polyvinyl alcohol or gelatin. US6228288 discloses a polymer film conductive composition.

The present invention seeks to mitigate against one or more of the problems mentioned above.

In accordance with a first aspect of the present invention, there is provided a method of forming an electrically-conductive, transparent solid material, said method comprising:
(i) Providing a liquid composition comprising a matrix-forming material and a plurality of metal nanowires; and
(ii) Forming said transparent solid material from said liquid composition;

Characterised in that
the method comprises forming a free-standing film of said liquid composition and forming a solid free-standing film from the free-standing film of the liquid composition.

The applicant has discovered that such a method may be effective in providing a transparent, optically-conductive solid material.

The term "liquid composition" indicates that the composition behaves like a liquid, not that all components thereof are liquid. It is anticipated that a substantial proportion of the liquid composition will be provided by components that are, themselves, liquid. For example, as mentioned below, optionally the matrix-forming material may be a liquid. Alternatively or additionally, the liquid composition may comprise a carrier liquid in which the matrix-forming material and plurality of nanowires are dispersed.

The solid material so produced may be in the form of a sheet, film or layer. Such a sheet, film or layer may optionally be of substantially uniform thickness, but this is not essential. The solid material so produced is in the form of a free-standing film. "Free-standing" indicates that there is no underlying substrate which supports said film. A free-standing liquid film may be formed, for example, by dipping a loop into said liquid composition, with the film forming inside the loop.

The solid material so produced typically comprises metal nanowires dispersed in a matrix, the matrix being formed from the matrix-forming material. The nature of the matrix and the matrix-forming material is discussed below.

Forming a solid material from said liquid composition may comprise initiating a liquid to solid phase transition. For example, the liquid composition may comprise one or more cross-linkers or gelling agents that, on heating or on exposure to a certain type of electromagnetic radiation, form a solid. Additionally or alternatively, the composition may, for example, comprise one or more monomers which react to form a solid polymer, for example, on exposure to a certain stimulus, such as exposure to a certain type of electromagnetic radiation, for example ultraviolet radiation.

The liquid composition may comprise a carrier liquid in which the matrix-forming material and plurality of metal nanowires are dispersed. In this case, forming a solid material from said liquid composition may additionally or alternatively comprise removing the carrier liquid to form said solid material.

The matrix-forming material may be a liquid. Additionally or alternatively, a carrier liquid may be provided, as mentioned above.

If a carrier liquid is present, the matrix-forming material may optionally be dissolved in the carrier liquid. Alternatively or additionally, the matrix-forming material may optionally be suspended in the carrier liquid.

The term "metal nanowire" refers to a metallic wire comprising one or more of elemental metal, metal alloys or metal compounds (such as metal oxides). For the avoidance of doubt, the term "metal nanowire" includes hollow wires and those which are not hollow. The metal nanowires may be made from any suitable metal, and may optionally comprise one or more of silver, gold, copper and nickel. The metal nanowires may optionally comprise one or more of silver and gold, and may optionally comprise silver (optionally in the absence of gold, nickel and copper). Silver nanowires may be particularly effective in providing electrically-conductive nanowires.

The metal nanowires may optionally have a mean aspect ratio (length/width) of at least 100:1, optionally at least 200:1, optionally at least 500:1, optionally from 200:1 to 3,000:1 and optionally from 250:1 to 2000:1. Nanowires with high aspect ratios may be particularly effective at forming electrically-conductive solid materials.

The metal nanowires optionally have a mean length of at least 10 microns, optionally at least 20 microns, optionally at least 30 microns, optionally no more than 100 microns and optionally from 20 to 50 microns. Nanowires having a mean length of from 20 to 50 microns may be particularly effective in forming electrically-conductive solid materials.

The metal nanowires optionally have a mean width of at least 10nm, optionally at least 20nm, optionally at least 30nm, optionally of at least 40nm, optionally no more than 100nm and optionally from 30 to 70nm.

The matrix-forming material may optionally be water-soluble. This facilitates the use of water as a carrier liquid. Water is non-toxic and inexpensive compared to other carrier liquids (although it has a relatively high boiling point and may therefore require more energy to remove). The liquid composition may optionally comprise one or more surfactants. Such surfactants may assist in dispersing the metal nanowires so that the solid material formed has the desired optical and electrical properties. For example, surfactants may assist in inhibiting the formation of metal nanowire aggregates having a size comparable to the wavelength of visible light. One or more low molecular weight surfactants may optionally be provided in the liquid composition. Low molecular weight surfactants optionally have a molecular mass of less than 2000, optionally less than 1000. Alternatively or additionally, the liquid composition may comprise one or more polymeric surfactants. Such polymeric surfactants may provide the matrix-forming material. Polymers which exhibit surfactant behaviour and which may also form the matrix include polyvinyl alcohol, for example. The liquid composition may comprise one or more polymeric surfactants in the absence of low molecular weight surfactants.

The matrix-forming material may optionally comprise one or more matrix-forming material precursors which form the matrix. Optionally, the matrix may comprise polymeric material, and said precursors may optionally comprise one or more monomers which form a polymer. For example, the one or more precursors may form the matrix on being exposed to a stimulus, such as heating, or exposure to electromagnetic radiation having certain characteristics.

The matrix may have a relative permittivity (measured at 1MHz) of from 1.5 to 30, optionally from 1.5 to 25, optionally from 1.5 to 20, optionally from 1.5 to 15, optionally from 1.5 to 10, optionally from 1.5 to 6, optionally from 1.5 to 3, optionally from 3 to 30, optionally from 5 to 25 and optionally from 15 to 25.

Additionally or alternatively, the matrix-forming material may optionally comprise one or more polymers. The one or more polymers may optionally be water soluble. At least one of said polymers may optionally exhibit surfactant-like behaviour. At least one of said polymers may optionally be a polymeric surfactant. At least one of said polymers may optionally be a block co-polymer, optionally with a hydrophilic block and a hydrophobic block. Such block copolymers may display surfactant behaviour. At least one of said polymers may comprise repeat units comprising moieties capable of forming hydrogen bonds with water. Such polymers may also exhibit surfactant-like behaviour. At least one of said polymers may comprise repeat groups comprising ether linkages. These polymers may display surfactant behaviour. The one or more polymers may optionally be selected from one or more of the group consisting of a poly(alkenol); a polyether; and a block co-polymer comprising one or more blocks of poly(alkenol) or polyether, with one or more blocks of a polymer comprising repeat groups of a tertiary amine.

The mean thickness of the solid material (typically if the solid material is in the form of a coating) may optionally be at least 10nm, optionally at least 50nm, optionally at least 200nm, optionally at least 500nm, optionally at least 1 micron, optionally no more than 10microns, optionally no more than 5 microns and optionally from 1 to 5 microns, optionally from 2 to 4 microns. The liquid composition and/or its method of deposition may be adapted to produce a solid material (especially a coating) having the mean thicknesses indicated above. The provision of a relatively thick matrix layer (at least 1 microns thick) may be beneficial in producing a relatively smooth surface, even when the underlying surface is rough.

In a merely illustrative example, the method may comprise the formation of a coating on a first substrate, in which case contacting the surface of the first substrate with the liquid composition may be performed using one or more of spin coating, dipping, spray coating and printing. Spin coating may optionally be used, for example, if a thinner coating is desired. Dipping, spray coating and printing may optionally be used for the production of thicker coatings. Printing includes, but is not limited to, screen printing, flexographic printing and aerosol jet printing.

If formation of the solid material comprises removal of the carrier liquid, then removal of the carrier liquid may optionally be performed by evaporation of the carrier liquid. This may optionally be effected by heating the liquid, for example, in an oven. The carrier liquid may optionally be evaporated by reducing the ambient pressure to which the carrier liquid is subjected. The carrier liquid may optionally be removed by heating the carrier liquid and reducing the ambient pressure to which the carrier liquid is subjected. If the liquid is heated, the temperature to which the liquid is heated will depend, inter alia, on the liquid itself and the ambient pressure to which the liquid is subjected. If the temperature is low, then evaporation of the carrier liquid will be relatively slow, which may be undesirable. If the temperature is high, then evaporation of the carrier liquid will be relatively rapid. Whilst this may be desirable, it may not be desirable to evaporate the liquid too quickly, because unwanted effects (such as bubbling of the matrix), may occur. At atmospheric pressure, if the carrier liquid is water, then the carrier liquid may optionally be heated to at least 40°C, optionally at least 50°C, optionally at least 60°C, optionally no more than 80°C and optionally no more than 70°C.

It may optionally be desirable to include in said liquid composition one of more of the following components; adhesion promoter, dye, corrosion inhibitor, refractive index modifier and viscosity modifier. Corrosion inhibitors may optionally comprise one or more of aromatic triazoles, imidazoles and thiazoles. Refractive index modifiers may optionally comprise silicon oxide. Viscosity modifiers may optionally comprise one or more of cellulose, cellulose derivatives, gums (such as xanthan gum) and glycols.

The liquid composition may optionally comprise no more than 10wt% metal nanowires, optionally no more than 8wt%, optionally no more than 6wt%, optionally no more than 1wt%, optionally no more than 0.8wt%, optionally no more than 0.6wt%, optionally at least 0.001wt%, optionally at least 0.01wt%, optionally at least 0.1wt%, and optionally from 0.1wt% to 0.6wt% metal nanowires.

The liquid composition may optionally comprise no more than 10wt% matrix-forming material, optionally no more than 8wt%, optionally no more than 6wt%, optionally at least 0.001wt%, optionally at least 0.1wt% and optionally from 0.1wt% to 0.6wt% matrix-forming material.

The liquid composition may optionally comprise at least 0.1wt% metal nanowires and at least 0.1wt% matrix-forming material, optionally when the matrix-forming material comprises a polymer (typically a polymer having surfactant properties, such as poly(vinyl alcohol)). The liquid composition may optionally comprise 0.1 to 0.6wt% metal nanowires and 0.1 to 0.6wt% matrix-forming material, optionally when the matrix-forming material comprises a polymer (typically a polymer having surfactant properties, such as poly(vinyl alcohol)).

The ratio of the weight of the matrix-forming material relative to the sum of the weight of the matrix-forming material and the metal nanowires may optionally be no more than 0.5:1, optionally no more than 0.4:1, optionally at least 0.05:1 and optionally from 0.05:1 to 0.4:1.

The ratio of the volume of the matrix-forming material relative to the sum of the volume of the matrix-forming material and the metal nanowires may optionally be no more than 0.9:1, optionally no more than 0.8:1, optionally no more than 0.7:1, optionally at least 0.05:1 and optionally from 0.05:1 to 0.6:1.

If the matrix-forming material comprises one or more polymers, then optionally at least one polymer has an average molecular weight (Mₙ) of at least 5000, optionally at least 10,000, optionally at least 20,000, optionally at least 50,000, optionally no more than 500,000 and optionally no more than 250,000. At least one polymer may optionally have a degree of polymerisation of at least 100, optionally at least 200, optionally at least 500, optionally at least 1000, optionally no more than 10,000 and optionally no more than 5000.

The carrier liquid, if present, is optionally an aqueous liquid i.e. it optionally comprises water. The carrier liquid may optionally be a polar liquid or comprise a mixture of polar liquids. The carrier liquid may comprise one or more of water, dimethyl sulfoxide, tetrahydrofuran, dimethylformamide, acetic acid, acetonitrile, ethanol, methanol and acetone. The carrier liquid may comprise water and/or a water-miscible liquid. The carrier liquid may have a polarity index of at least 4 (Burdick & Jackson polarity index).

In a merely illustrative example, the method may comprise the formation of a solid coating on a first substrate, and transferring the coating from said first substrate to a second substrate. This illustrative method may optionally comprise contacting a surface of the second substrate with a surface of said coating, and moving said first substrate and said second substrate away from one another. Such movement comprises relative movement of the first and second substrates away from one another. One or both of the first and second substrates may be moved. For example, the first substrate may be kept still and the second substrate moved.

In a merely illustrative example, the method may comprise the formation of a coating on a first substrate, and the first substrate (and second substrate, if present) may comprise a substrate for an electrical or opto-electrical device, such as a display (for example, a liquid crystal display) or a photovoltaic device. The first (and second, if present) substrate may be substantially rigid (for example, if the substrate is made from glass) or flexible (for example, if the substrate is made from a polymer). Said surface onto which the liquid composition is deposited may be provided by glass, for example, or may optionally be provided by a barrier layer, for example. Such barrier layers are typically applied to glass to inhibit the unwanted leaching of sodium ions. The first substrate (and second substrate, if present) may be porous.

Those skilled in the art will understand the meaning of the term "electrically-conductive". The sheet resistance of the solid material (particularly if the solid material is in the form of a coating) may optionally be no more than 1000Ω/square, optionally no more than 500Q/square, optionally no more than 250Q/square, optionally no more than 1000Ω/square, optionally no more than 50Ω/square, optionally at least 1Ω/square, optionally from 1 to 1000Ω/square, optionally from 1 to 75Q/square and optionally from 5 to 60Q/square.

The meaning of the term "transparent" will be readily apparent to those skilled in the art. The percentage light transmission (typically measured using a UV-vis spectrometer in transmission mode in the visible region (390-750nm wavelength light) against a reference substrate) of the solid material (particularly if formed as a coating) at a thickness of 2.5 microns is optionally at least 50%, optionally at least 60% and optionally at least 70%. The optical absorption coefficient of the solid material may optionally be no more than 0.1/micron, optionally no more than 0.08/micron and optionally no more than 0.06/micron. The optical absorption coefficient may be calculated using the Beer-Lambert law, using optical transmission measurements made using a UV-vis spectrometer in transmission mode in the visible region (390-750nm wavelength light) against a reference substrate.

The solid material and liquid composition should optionally be arranged so that the amount of light scattered by the solid material is acceptable. Without wishing to be constrained by theory, it is believed that light scatter may be caused by the formation of metal nanowire aggregates which are of a similar size to the wavelength of incident light. Therefore, without wishing to be constrained by theory, it is understood that it is important to inhibit the formation in the liquid composition of such aggregates(for example, by limiting the formation of nanowire aggregates having a size of more than 400nm by adding one or more surfactants to the liquid composition. The haze (a measure of light scatter) generated by the solid material (and particularly if the solid material is in the form of a coating) may be no more than 20%, optionally no more than 10%, optionally no more than 8%, optionally no more than 5% and optionally no more than 2%. Haze may be measured using a method well known to those skilled in the art, such as ASTM D1003-95.

Whilst not wishing to be constrained by theory, the applicant believes that the affinity of the matrix-forming material for the metal nanowires may be important to the electrical and optical properties of the solid material, particularly if the solid material is in the form of a coating. Certain matrix-forming materials have been observed to inhibit the formation of a conductive network of nanowires; for example, polyvinylpyrrolidone (PVP) appears to have a strong affinity for silver nanowires, and it is thought that PVP effectively forms an insulating layer around nanowires and inhibits the nanowire-nanowire contact which is necessary to form an electrically-conductive network. Whilst not wishing to be constrained by theory, it is believed that matrix-forming materials which have no affinity for the metal nanowires will lead to the formation of aggregates of nanowires; such aggregates may cause unwanted scattering of light as indicated above and may inhibit the formation of an effective electrically-conductive network of nanowires. The applicant believes that the matrix-forming material may optionally be selected to provide a solid material (particularly a coating) in which the aggregation of nanowires is on a length scale which is less than the wavelength of visible light. This may optionally be achieved by providing a matrix-forming material that has a weak electrostatic affinity for the metal nanowires, but provides strong steric stabilisation. Whilst not wishing to be bound by theory, the applicant understands that strong steric stabilisation may be obtained using a polymer of high molecular weight. The molecular weight of the polymer may optionally be greater than 500, optionally greater than 1000 and optionally greater than 5000.

The method is optionally arranged to provide a solid material and particularly a coating comprising metal nanowires distributed approximately uniformly throughout the thickness of the solid material (and particularly throughout the thickness of a coating). The density of the nanowires in the upper half of the solid material (and particularly in the upper half of a coating) may optionally be from 50-150% (optionally from 70-130%, optionally from 80 to 120%) of the density of the nanowires in the lower half of the solid material (and particularly in the lower half of a coating).

In accordance with a merely illustrative example, there is provided a free-standing film of transparent, electrically-conductive solid material produced in accordance with a method of the first aspect of the present invention. The solid material may optionally have the properties of the solid material discussed above in relation to the method of the first aspect of the present invention. The solid material is optionally a coating, as described in accordance with the method of the first aspect of the present invention.

An illustrative example provides an electrically-conductive transparent solid material comprising a plurality of metal nanowires dispersed within a matrix.

The solid material of the illustrative example may optionally comprise those features described above in relation to the method of the first aspect of the present invention. The nanowires and matrix of the solid material of the illustrative example may comprise those features described above in relation to the method of the first aspect of the present invention and/or the solid material of the second aspect of the present invention. For example, the matrix may optionally comprise one or more polymers. For example, the solid material may be in the form of a coating. For example, the mean thickness of the solid material may be at least 1 micron.

The ratio of the weight of the matrix-forming material relative to the sum of the weights of the matrix-forming material and the metal nanowires may optionally be no more than 0.5:1, optionally no more than 0.4:1, optionally at least 0.05:1 and optionally from 0.05:1 to 0.4:1.

The ratio of the volume of the matrix-forming material relative to the sum of the volumes of the matrix-forming material and the metal nanowires may optionally be no more than 0.9:1, optionally no more than 0.8:1, optionally no more than 0.7:1, optionally at least 0.05:1 and optionally from 0.05:1 to 0.6:1.

The metal nanowires may optionally be distributed approximately uniformly throughout the thickness of the solid material, particularly if the solid material is in the form of a coating. The density of the nanowires in the upper half of the solid material may optionally be from 50-150% (optionally from 70-130%, optionally from 80 to 120%) of the density of the nanowires in the lower half of the solid material, particularly if the solid material is in the form of a coating.

The solid material of the illustrative example may be made using the method of the first aspect of the present invention, and therefore the solid material of the illustrative example may comprise the features of the method of the first aspect of the present invention.

Also described is a substrate provided with an electrically-conductive, transparent coating produced in accordance with a method of the first aspect of the present invention, or a substrate provided with an electrically-conductive, transparent coating according to the second aspect of the present invention or the illustrative example.

The substrate may comprise a substrate for an electrical or opto-electrical device, such as a display (for example, a liquid crystal display) or a photovoltaic device. The substrate may be substantially rigid (for example, if the substrate is made from glass) or flexible (for example, if the substrate is made from a flexible polymer). Said surface onto which the liquid composition is deposited may be provided by glass, for example, or may optionally be provided by a barrier layer, for example. Such barrier layers are typically applied to glass to inhibit the unwanted leaching of sodium ions.

The substrate may be provided with those features typically provided to a substrate for an electrical or opto-electrical device. For example, the substrate may be provided with a plurality of electrically-conductive paths or tracks for transmitting electrical signals to said coating. The substrate may be provided with one or more spacers suitable for establishing a gap between two electrodes.

The substrate may be provided with one or more overlayers applied to said coating. For example, if the substrate is to form part of a liquid crystal device (such as a display), an alignment layer may be provided, such as a layer of a rubbed polymer (such as a polyamide or polyimide).

A further illustrative example provides a liquid composition for forming a transparent electrically-conductive solid material (particularly a coating), the liquid composition comprising a matrix-forming material and a plurality of metal nanowires. The liquid composition may comprise a carrier liquid, the matrix-forming material and the plurality of nanowires being dispersed in the carrier liquid. The liquid composition may comprise those features described above in relation to the method of the first aspect of the present invention.

The prevent invention will now be described by way of example only with reference to the following figures of which:
Figure 1 is a photograph of the belted crest device of the University of Oxford, part of which (the top left) is covered with a substrate which has been provided with a coating made using an illustrative example;
Figure 2 is a cross-sectional scanning electron microscope image of a coating made using an illustrative example;
Figure 3 is a plan view scanning electron microscope image of a coating made using an illustrative example;
Figure 4 is a graph showing the sheet resistance of a coating made using an illustrative example as a function of the wt% of polyvinyl alcohol relative to the sum of the weights of polyvinyl alcohol and silver nanowires;
Figure 5 is a graph showing the optical transmission of a coating made using an illustrative example as a function of the wt% of polyvinyl alcohol relative to the sum of the weights of polyvinyl alcohol and silver nanowires; and
Figure 6 is a graph showing the optical transmission of a coating made using an illustrative example as a function of sheet resistance of the coating.

A general example of an illustrative method will now be described. Silver nanowires were made essentially as described in "Rapid synthesis of silver nanowires through a CuCl- or CuCl2-mediated polyol process", K.E.Korte et al., J. Mat. Chem., 2008, vol. 18, pages 437-441. Instead of using an oil bath to heat the reaction (as
described by Korte et al.), the applicant used a hot plate and glass wool. Optical transmission spectroscopy of aliquots of the reaction mixture in the UV-visible spectrum was used to monitor the progress of the reaction, a peak in absorption at about 400nm indicating the presence of nanowires. The silver nanowires were characterised in several ways. The nanowires were deposited from suspension onto a substrate for examination using scanning electron microscopy (SEM). The SEM images allowed the size of the nanowires to be examined. Transmission electron microscopy was used to examine individual nanowires.

A suspension of nanowires in a carrier liquid was then prepared. A separate solution of polymer in the carrier liquid was prepared. An appropriate amount of the polymer solution was then combined with an appropriate amount of the suspension of nanowires to produce a liquid composition for depositing onto a substrate. The liquid composition was deposited onto a substrate (typically glass) using an off-the-shelf, low cost spray system to form a liquid layer on the substrate. The carrier liquid was then removed by heating the substrate and liquid layer to about 50°C.

The thickness of the coating was investigated using scanning electron microscopy (using a JEOL 840F).

The optical characteristics of the coating could be observed by eye and by measuring the optical transmission of the coating. This was performed using a UV-vis spectrometer in transmission mode in the visible region (390-750nm wavelength light) against a reference substrate. The coating could also be examined using scanning electron microscopy.

The sheet resistance of the coating was measured using a 4-point probe, as is well known to those skilled in the art.

### Illustrative Example 1

A 1wt% suspension of silver nanowires in water was prepared. A 1wt% solution of polyvinyl alcohol (PVA) in water was prepared. In the present example, the PVA was 99+% hydrolysed, having an average M_{W} of 85000 to 124000 (Aldrich, UK). The PVA solution and the silver nanowire suspension were mixed in appropriate amounts to form the liquid composition for forming the coating. The coating was formed as described above in the general method.

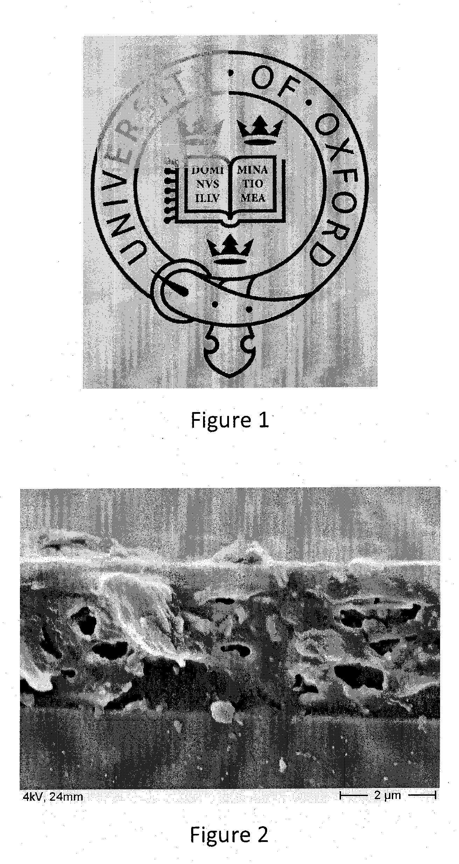

Figure 1 shows a photograph of the University of Oxford logo, with a substrate and coating formed in accordance with the method of Illustrative Example 1 placed over the top left part of the logo. The coating was formed from a liquid comprising the same weights of PVA and silver nanowires. As can be seen from Figure 1, whilst the coating exhibits some unwanted scattering (giving rise to a slight "misting effect"), the coating is substantially transparent.

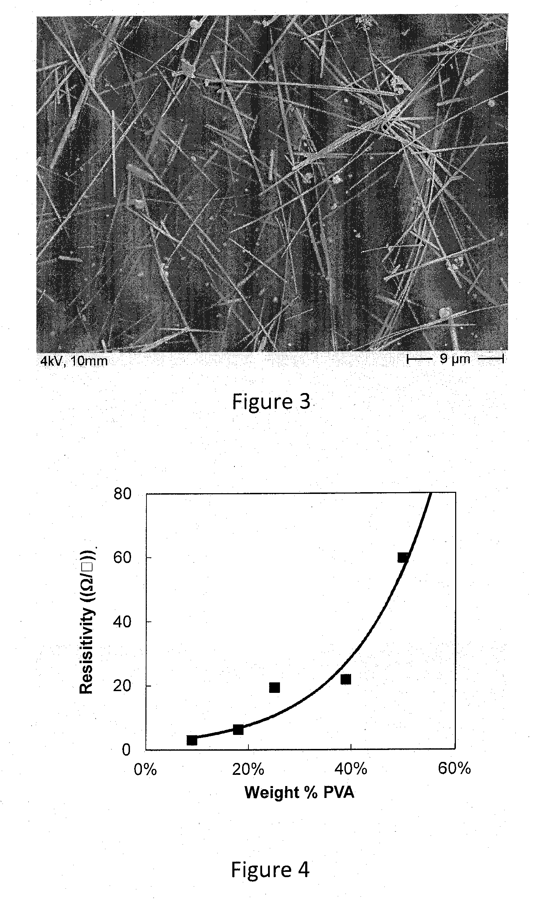

Figures 2 and 3 show scanning electron micrograph images of coatings formed in accordance with Illustrative Example 1. The weight ratio of PVA:silver nanowires was 60:40. Figure 2 shows that the coating is relatively thick (about 3microns thick). This may be beneficial when applying coatings to relatively rough underlying substrates. Figure 3 indicates that the silver nanowires have a high aspect ratio, and are relatively evenly dispersed in a lateral direction throughout the coating. There appears to be significant contact between adjacent nanowires (thereby enhancing conductivity), whilst there appears to be little aggregation of nanowires over distances comparable to the wavelength of light (such aggregation causing unwanted scattering of light).

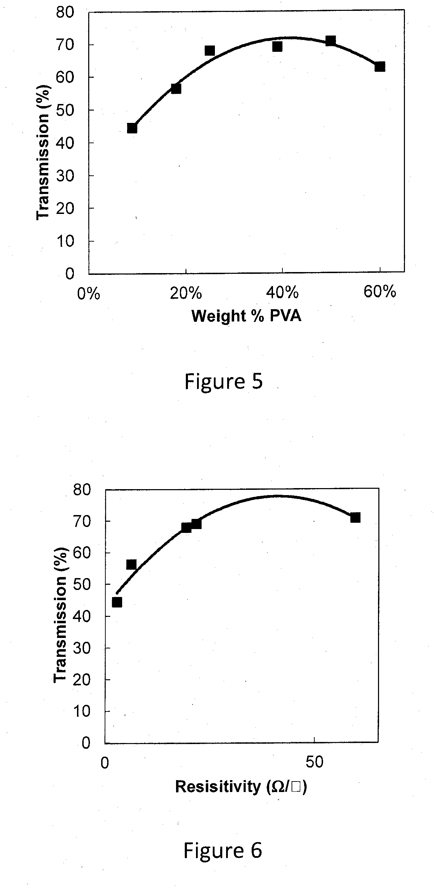

Figure 4 shows the sheet resistance of a coating made using Illustrative Example 1. Different amounts of silver nanowire suspension and polymer solution were mixed in order to vary the weight percentage of polymer. As can be seen from Figure 4, the sheet resistance values are low, certainly compared to commercially available indium tin oxide. As the percentage weight of the polymer decreases, the sheet resistance decreases. Referring now to Figure 5, it was observed that the % optical transmission was at a consistent level of from 60-70% for a percentage weight of polymer of from about 25% to 60%, but as the percentage weight of the polymer decreased below about 25%, the % optical transmission dropped considerably.

Figure 6 shows the % optical transmission as a function of sheet resistance. The data shown in Figure 6 were derived from the data of Figures 4 and 5. This suggests that there is a range of optimum values of resistivity which produce good optical transmission.

### Illustrative Example 2

The method of Illustrative Example 1 was reproduced using methanol as the carrier liquid. The coatings produced were optically and electrically acceptable.

### Illustrative Example 3

The method of Illustrative Example 1 was reproduced using tetrahydrofuran as the carrier liquid. The coatings produced were optically and electrically acceptable.

### Illustrative Example 4

The method of Illustrative Example 1 was reproduced using isopropyl alcohol as the carrier liquid. The coatings produced were optically and electrically acceptable, if the liquid composition comprising the carrier liquid, metal nanowires and the polymer was used quickly after preparation.

### Illustrative Example 5

The method of Illustrative Example 1 was reproduced using polyvinylpyrrolidone (Aldrich catalogue #85,656-8, M_{W} of about 55000, Aldrich, UK) instead of PVA, but was unsuccessful. Whilst not wishing to be constrained by theory, it is thought that the polymer inhibits contact between metal nanowires, thereby inhibiting electrical conductivity. Furthermore, poor quality films were formed by spray coating.

### Illustrative Example 6

The method of Illustrative Example 1 was reproduced using PEDOT.ESS (Clevios P polymer, H.C.Starck GmbH, Germany) instead of PVA, but was relatively unsuccessful. Without wishing to be bound by theory, the applicant believes that the liquid used was too viscous.

The illustrative examples above illustrate the use of spray dispensing to form a liquid layer on a substrate. Th 20 to 24ose skilled in the art will realise that alternative methods for forming a layer may be used, for example, dipping or screen printing. Screen printing may be of particular benefit because screen printing permits effective deposition of the liquid composition through a screen onto substrates to generate patterning, for example, by providing strips or regions of coating separated by electrically-isolating gaps.

The illustrative examples above illustrate the use of polyvinyl alcohol as a polymer from which the layer is formed. Those skilled in the art will realise that other materials may be used. For example, alternative polymers could be used, such as other polymers which have surfactant properties, such as polyethers, poly(methyl methacrylate) and substituted polystyrenes. Alternatively or additionally, other materials could be used, such as monomer or low molecular mass moieties which form polymers in the layer, for example, on exposure to a stimulus, such as illumination with UV or other suitable electromagnetic radiation.

The illustrative examples above describe the production of relatively thick films. Whilst this may be desirable in certain circumstances, it is possible to make thinner films, for example from 10 to 100 nm thick.

The illustrative examples above describe the deposition of coatings onto a substrate. Whilst this may be desirable in certain circumstances, it may be desirable to make a solid material which is not in the form of a coating but rather, for example, in the form of a free-standing film.

The illustrative examples above describe the use of a liquid composition comprising a carrier liquid which is subsequently removed, for example, by heating. Whilst this may be desirable in certain circumstances, it may be desirable not to have a carrier liquid, for instance, if the matrix-forming material itself is a liquid.

The illustrative examples above describe the use of silver nanowires. Those skilled in the art will realise that, additionally or alternatively, different metal nanowires may be used, for example, gold nanowires. Furthermore, additional conductive species, such as carbon nanostructures, could be added.

The illustrative examples above illustrate the use of a liquid composition comprising a polymer and metal nanowires to produce a conductive film. Those skilled in the art will realise that it would be possible to add further components to the liquid composition, such as one or more of a low molecular weight surfactant, an adhesion promoter, dye, a corrosion inhibitor, a refractive index modifier and a viscosity modifier.

Where in the foregoing description, integers or elements are mentioned which have known, obvious or foreseeable equivalents, then such equivalents are herein incorporated as if individually set forth. Reference should be made to the claims for determining the true scope of the present invention, which should be construed so as to encompass any such equivalents. It will also be appreciated by the reader that integers or features of the invention that are described as preferable, advantageous, convenient or the like are optional and do not limit the scope of the independent claims.

## Claims

1. A method of forming an electrically-conductive, transparent solid material, said method comprising:
(i) Providing a liquid composition comprising a matrix-forming material and a plurality of metal nanowires; and
(ii) Forming said transparent solid material from said liquid composition,
**characterised in that**
the method comprises forming a free-standing film of said liquid composition and forming a solid free-standing film from the free-standing film of said liquid composition.

2. A method according to claim 1 wherein the liquid composition comprises a carrier liquid in which the matrix-forming material and plurality of metal nanowires are dispersed, and wherein forming a solid coating from said composition comprises removing the carrier liquid to form said solid material.

3. A method according to claim 2 wherein the carrier liquid is a polar liquid or comprises a mixture of polar liquids.

4. A method according to any preceding claim wherein the metal nanowires comprise one or more of silver, gold, copper and nickel.

5. A method according to any preceding claim wherein the matrix-forming material comprises one or more polymers.

6. A method according to claim 5 wherein at least one of said polymers exhibits surfactant-like behaviour.

7. A method according to any preceding claim wherein the liquid composition comprises no more than 1wt% metal nanowires.

8. A method according to any preceding claim wherein the liquid composition comprises no more than 1wt% matrix-forming material.

9. A method according to any preceding claim wherein the liquid composition comprises 0.1 to 0.6wt% metal nanowires and 0.1 to 0.6wt% matrix-forming material, and the matrix-forming material comprises a polymer.

10. A method according to any preceding claim wherein the ratio of the weight of the matrix-forming material relative to the sum of the weight of the matrix-forming material and the metal nanowires is no more than 0.5:1 and at least 0.05:1.

## Patentansprüche

1. Verfahren zum Bilden eines elektrisch leitenden, transparenten festen Materials, wobei das Verfahren umfasst:
(i) Bereitstellen einer flüssigen Zusammensetzung, umfassend ein matrixbildendes Material und eine Vielzahl von MetallNanodrähten; und
(ii) Bilden des transparenten festen Materials aus der flüssigen Zusammensetzung,
**dadurch gekennzeichnet, dass**
das Verfahren das Bilden eines freistehenden Films aus der flüssigen Zusammensetzung und das Bilden eines festen freistehenden Films aus dem freistehenden Film aus der flüssigen Zusammensetzung umfasst.

2. Verfahren nach Anspruch 1, wobei die flüssige Zusammensetzung eine Trägerflüssigkeit umfasst, in der das matrixbildende Material und die Vielzahl von Metallnanodrähten dispergiert sind und wobei das Bilden einer festen Beschichtung aus der Zusammensetzung das Entfernen der Trägerflüssigkeit zur Bildung des festen Materials umfasst.

3. Verfahren nach Anspruch 2, wobei die Trägerflüssigkeit eine polare Flüssigkeit ist oder eine Mischung polarer Flüssigkeiten umfasst.

4. Verfahren nach einem der vorhergehenden Ansprüche, wobei die Metallnanodrähte eines oder mehrere von Silber, Gold, Kupfer und Nickel umfassen.

5. Verfahren nach einem der vorhergehenden Ansprüche, wobei das matrixbildende Material ein oder mehrere Polymere umfasst.

6. Verfahren nach Anspruch 5, wobei mindestens eines der Polymere ein tensidartiges Verhalten zeigt.

7. Verfahren nach einem der vorhergehenden Ansprüche, wobei die flüssige Zusammensetzung nicht mehr als 1 Gew.-% Metall-Nanodrähte umfasst.

8. Verfahren nach einem der vorhergehenden Ansprüche, wobei die flüssige Zusammensetzung nicht mehr als 1 Gew.-% matrixbildendes Material enthält.

9. Verfahren nach einem der vorhergehenden Ansprüche, wobei die flüssige Zusammensetzung 0,1 bis 0,6 Gew.-% Metallnanodrähte und 0,1 bis 0,6 Gew.-% matrixbildendes Material umfasst und das matrixbildende Material ein Polymer umfasst.

10. Verfahren nach einem der vorhergehenden Ansprüche, wobei das Verhältnis des Gewichts des matrixbildenden Materials zur Summe des Gewichts des matrixbildenden Materials und der Metall-Nanodrähte nicht mehr als 0,5:1 und mindestens 0,05:1 beträgt.

## Revendications

1. Un procédé de formation d'un matériau solide transparent électro-conducteur, ledit procédé comprenant:
(i) la fourniture d'une composition liquide comprenant un matériau formant une matrice et une pluralité de nanofils métalliques; et
(ii) la formation dudit matériau solide transparent à partir de ladite composition liquide,
**caractérisé en ce que** ce procédé comprend la formation d'un film autoporteur de ladite composition liquide et la formation d'un film autoporteur solide à partir du film autoporteur de ladite composition liquide

2. Un procédé selon la revendication 1, dans lequel la composition liquide comprend un liquide porteur dans lequel le matériau formant la matrice et la pluralité de nanofils métalliques sont dispersés et dans lequel la formation d'un revêtement solide à partir de ladite composition comprend l'élimination du liquide porteur pour former ledit matériau solide.

3. Un procédé selon la revendication 2, dans lequel le liquide porteur est un liquide polaire ou comprend un mélange de liquides polaires.

4. Un procédé selon l'une quelconque des revendications précédentes, dans lequel les nanofils métalliques comprennent un ou plusieurs des métaux consistant en argent, or, cuivre et nickel.

5. Un procédé selon l'une quelconque des revendications précédentes, dans lequel le matériau formant la matrice comprend un ou plusieurs polymères.

6. Un procédé selon la revendication 5, dans lequel au moins l'un desdits polymères présente un comportement de type tensioactif.

7. Un procédé selon l'une quelconque des revendications précédentes, dans lequel la composition liquide ne comprend pas plus de 0,1% en poids de nanofils métalliques.

8. Un procédé selon l'une quelconque des revendications précédentes, dans lequel la composition liquide ne comprend pas plus de 1% en poids de matériau formant la matrice.

9. Un procédé selon une quelconque des revendications précédentes, dans lequel la composition liquide comprend 0,1 à 0,6% en poids de nanofils métalliques et 0,1 à 0,6% en poids de matériau formant la matrice, et le matériau formant la matrice comprend un polymère.

10. Un procédé selon l'une quelconque des revendications précédentes, dans lequel le rapport entre le poids du matériau formant la matrice et la somme du poids du matériau formant la matrice et des nanofils métalliques n'est pas supérieur à 0,5/1 et d'au moins 0,05/1.
